Europäisches Patentamt

European Patent Office

Office européen des brevets

(19)

(11) Numéro de publication: **0 152 353**
**A1**

(12) # DEMANDE DE BREVET EUROPEEN

(21) Numéro de dépôt: **85400213.6**

(22) Date de dépôt: **08.02.85**

(51) Int. Cl.⁴: **H 01 L 31/02**
**H 01 L 31/10**

(30) Priorité: **10.02.84 FR 8402068**

(43) Date de publication de la demande:
**21.08.85 Bulletin 85/34**

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Descure, Pierrick**
**THOMSON-CSF SCPI 173, bld Haussmann**
**F-75379 Paris Cedex 08(FR)**

(74) Mandataire: **Mayeux, Michèle et al,**
**THOMSON-CSF SCPI 173, Bld Haussmann**
**F-75379 Paris Cedex 08(FR)**

(54) **Dispositif photosensible avec filtres intégrés pour la séparation des couleurs, et procédé de fabrication.**

(57) Les filtres pour la séparation des couleurs sont des filtres interférentiels qui, comme les détecteurs sont des transistors MOS, sont réalisés par les diverses couches de différents matériaux (5, 7, 9) recouvrant le substrat semi-conducteur (1) pour constituer les transistors MOS. On modifie l'épaisseur $(e_2, e_3)$ de la couche en matériau isolant (5) recouvrant le substrat semi-conducteur (1) pour obtenir la transimission spectrale désirée pour chaque filtre.

FIG_1-e

EP 0 152 353 A1

Croydon Printing Company Ltd.

# DISPOSITIF PHOTOSENSIBLE AVEC FILTRES INTEGRES POUR LA SEPARATION DES COULEURS ET PROCEDE DE FABRICATION

La présente invention concerne un dispositif photosensible avec filtres intégrés pour la séparation des couleurs. Elle concerne également un procédé de fabrication d'un tel dispositif.

L'invention concerne le domaine des capteurs d'images à l'état solide qui comportent des détecteurs photosensibles intégrés sur un substrat semi-conducteur. Pour l'analyse d'images en couleurs, il est connu d'utiliser des filtres organiques colorés. Ces filtres sont constitués par la juxtaposition de pavés de gélatine, diversement colorés, par imprégnation. Ces filtres organiques peuvent être réalisés directement à la surface du dispositif photosensible ou peuvent être rapportés sur celui-ci.

L'utilisation de filtres organiques colorés présente notamment les inconvénients suivants :

- ces filtres sont instables avec la température et avec certains rayonnements ;

- ils sont difficilement réalisables sur de très petites dimensions ;

- de plus, il est nécessaire de prévoir sur ces filtres un réseau opaque définissant le contour des détecteurs en raison d'une part de la distance séparant les filtres de la surface sensible et en raison d'autre part de la mauvaise définition des pavés colorés des filtres. Ce réseau opaque provoque une diminution de l'ouverture du dispositif photosensible, définie comme le rapport entre la surface sensible du dispositif et sa surface totale ;

- par ailleurs l'adjonction à un dispositif photosensible d'un filtre organique coloré entraîne une diminution de la transmission du dispositif photosensible, de l'ordre de 30 % dans certains cas.

La présente invention propose d'utiliser à la place de ces filtres organiques, des filtres interférentiels qui ne présentent pas les inconvénients des filtres organiques.

Par la demande de brevet françaais 2.362.412 on connait des filtres interférentiels pour photo-détecteurs. Ces filtres sont constituées de plusieurs couches déposées à la surface des détecteur.

La présente invention concerne les dispositifs photosensibles dont les détecteurs sont des transistors MOS.

Ce type de détecteurs bien connu présente beaucoup d'avantages, et notamment, une bonne sensibilité, une bonne résistance à la température, une grande simplicité favorable à la réduction du coût de fabrication, l'absence de rémanence...

Le grand inconvénient des détecteurs à transistors MOS est l'existence de phénomènes d'interférences dus aux diverses couches de matériaux recouvrant le substrat semi-conducteur, pour constituer les transistors MOS.

L'invention résoud le problème dû aux phénomènes d'interférences en utilisant les couches recouvrant le susbtrat semi-conducteur, dans le cas où les détecteurs sont des transistors MOS, comme filtres interférentiels intégrés assurant la séparation des couleurs.

La présente invention concerne un dispositif photosensible comportant des détecteurs photosensibles, intégrés sur un substrat semi-conducteur et munis de filtres interférentiels réalisés par plusieurs couches de différents matériaux (5, 7, 9) recouvrant le substrat semi-conducteur, caractérisé en ce que les détecteurs sont des transistors MOS et en ce que les filtres interférentiels assurent la séparation des couleurs et sont au moins constitués par :

- au moins une couche isolante en contact avec le substrat semi-conducteur qui sonstitue la couche diélectrique des transistors MOS ;

- une couche conductrice qui constitue la grille des transistors MOS.

On peut signaler que l'invention permet d'obtenir pour des dispositifs photosensibles, à transistors MOS, et du type interligne par exemple (présentant une alternance de registres soumis au rayonnement à détecter et de registres de lecture des charges) une sensibilité supérieure à celles obtenues dans le cas d'un dispositif du type interligne, avec couche photoconductrice et filtres organiques colorés ou dans le cas d'un dispositif à transfert de ligne, muni de filtres organiques colorés ; or ces deux derniers dispositifs présentent une ouverture supérieure à celle du dispositif à transistors MOS du type interligne.

D'autres objets, caractéristiques et résultats de l'invention ressortiront de la description suivante, donnée à titre d'exemple non limitatif et illustrée par les figures annexées qui représentent :

- les figures 1a à e, 2a à e, et 3a à e, des schémas illustrant trois procédés de fabrication d'un mode de réalisation d'un dispositif selon l'invention ;

- les figures 4a et b, des courbes illustrant, d'une part, les différences de capacités de stockages dues aux variations d'épaisseur de la couche isolante et, d'autre part, les résultats obtenus après compensation ;

- les figures 5a à e, des schémas illustrant un procédé de fabrication d'un mode de réalisation d'un dispositif selon l'invention ;

- les figures 6 et 7, des courbes de transmission illustrant les résultats obtenus d'une part avec des filtres tels que ceux représentés sur les figures 1e, 2e ou 3e et d'autre part avec des filtres tels que celui représenté sur la figure 5e ;

- la figure 8, le schéma d'un mode de réalisation d'un dispositif selon l'invention.

Sur les différentes figures, les mêmes repères désignent les mêmes éléments, mais, pour des raisons de clarté, les cotes et proportions de divers éléments ne sont pas respectées.

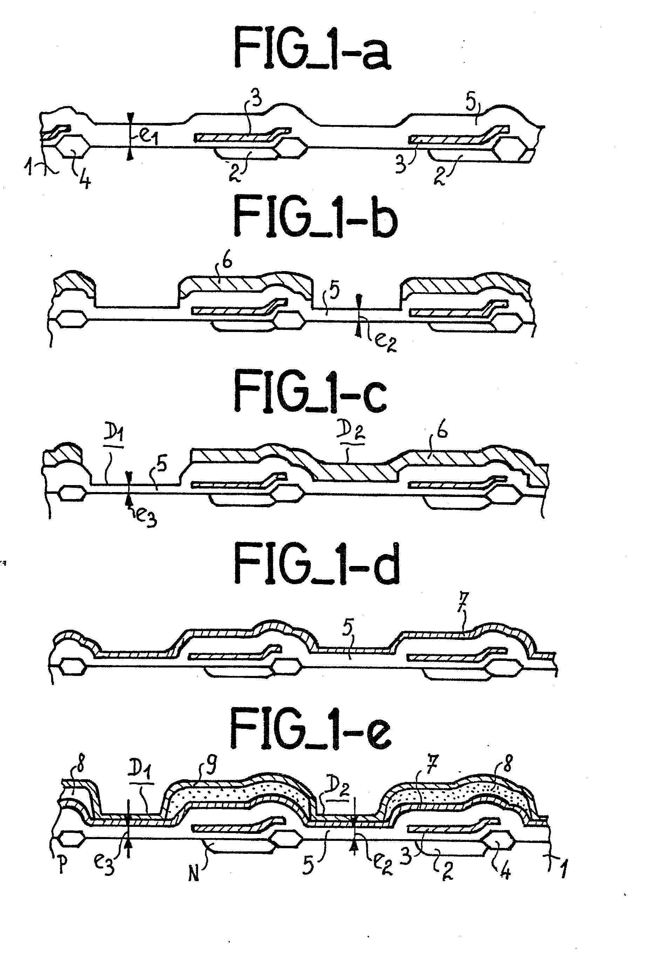

Les figures 1a à e illustrent un procédé de fabrication d'un mode de réalisation d'un dispositif selon l'invention.

On a pris à titre d'exemple un dispositif du type interligne. Les figures 1a à e sont des vues en coupe où il y a alternance d'un détecteur et d'un organe dans lequel les charges intégrées sont transférées pour être lues.

La figure 1e montre la structure du dispositif finalement obtenu. On y voit un substrat semi-conducteur 1, en silicium de type P par exemple.

Les organes servant au transfert et à la lecture des charges sont protégés du rayonnement à analyser par un masque en aluminium qui porte la référence 8. Ces organes sont des étages de registres CCD comportant sur le mode de réalisation de la figure 1e une zone 2 de type N, une électrode 3 en silicium polycristallin et une zone 4 qui sert à isoler latéralement chacun de ces organes des détecteurs dont il ne reçoit pas les charges.

Entre ces organes, on trouve les détecteurs du rayonnement à analyser qui sont des transistors MOS.

Sur la figure 1e, on voit deux de ces détecteurs référencés $D_1$ et $D_2$. Ces détecteurs sont constitués par le substrat semi-conducteur 1, recouvert d'une couche 5 en matériau isolant qui constitue la couche diélectrique habituelle des transistors MOS. On remarquera que l'épaisseur de cette couche est différente pour les détecteurs $D_1$ et $D_2$, épaisseur $e_3$ pour le détecteur $D_1$ et $e_2$ pour le détecteur $D_2$. Cette couche isolante est recouverte d'une couche conductrice 7 qui constitue la grille des transistors MOS. Une dernière couche isolante 9 recouvre généralement la couche conductrice 7.

Selon l'invention, les filtres des détecteurs $D_1$ et $D_2$ sont constitués par les couches précédemment énumérées qui font partie de la structure des détecteurs.

On choisit la nature et l'épaisseur des couches pour obtenir la transmission spectrale désirée pour chaque filtre, en jouant sur les effets d'interférence aux interfaces entre les couches et sur les réflexions et les transmissions, comme cela est connu dans la technique des filtres interférentiels.

Dans l'exemple de la figure 1e, on passe de l'air dont l'indice optique égale 1 à la couche isolante 9, en nitrure de silicium ou en oxyde de silicium par exemple, dont l'indice optique est voisin de 2 et qui joue le rôle de couche anti-reflet.

Ensuite, on trouve la couche conductrice 7, en silicium polycristallin par exemple, dont l'indice optique est élevé et voisin de 4.

Sous cette couche conductrice, se trouve la couche isolante 5, par exemple en silice, d'indice faible voisin de 1,45, puis le substrat, par exemple en silicium d'indice élevé voisin de 4.

On constate donc la présence de plusieurs couches de différents matériaux, avec alternance de couches d'indice élevé et d'indice faible, qui constituent un filtre interférentiel.

Dans le mode de réalisation de la figure 1e, on a choisi de jouer sur l'épaisseur de la couche en matériau isolant qui recouvre le substrat semi-conducteur pour obtenir la transmission spectrale désirée pour chaque filtre, alors que les autres couches ont la même épaisseur pour tous les filtres. Il est possible de choisir de modifier l'épaisseur d'un autre type de couche ou de plusieurs couches.

Sur la figure 1a, on voit que le substrat semi-conducteur 1 est recouvert de la couche isolante 5 dont l'épaisseur $e_1$ est forte devant les épaisseurs $e_2$ et $e_3$ que l'on cherche à obtenir.

Par exemple, on utilise une couche d'épaisseur $e_1$ égale à 1 micron pour obtenir des épaisseurs $e_2$ et $e_3$ de 1800 et 2200 $\overset{\circ}{A}$ par exemple.

Sur la figure 1b, on réalise une désoxydation partielle des détecteurs, par attaque plasma par exemple. Les organes de stockage et de lecture des charges sont protégés par une couche de résine 6.

On obtient ainsi une épaisseur d'oxyde $e_2$ qui est la plus forte épaisseur que l'on cherche à obtenir, par exemple on obtient l'épaisseur $e_2$ de sensiblement 2200 A.

Sur la figure 1c, on voit que l'on réalise une désoxydation complémentaire de la couche isolante 5 de façon à obtenir l'épaisseur $e_3$ de sensiblement 1800 A. Le détecteur $D_2$ et les organes de stockage et de lecture sont protégés par une couche de résine 6.

La figure 1d montre le dispositif obtenu après dépôt d'une couche conductrice 7.

La figure 1e montre le dispositif terminé, après dépôt de masques d'aluminium 8 sur les organes de stockage et de lecture, et après dépôt d'une couche isolante 9.

Il est bien entendu que si l'on désire obtenir d'autres épaisseurs de la couche isolante, il suffit de réaliser d'autres étapes de retrait complémentaire de cette couche - appelées étapes de désoxydation complémentaire s'il s'agit d'une couche d'oxyde - en protégeant les détecteurs dont la couche isolante a l'épaisseur souhaitée.

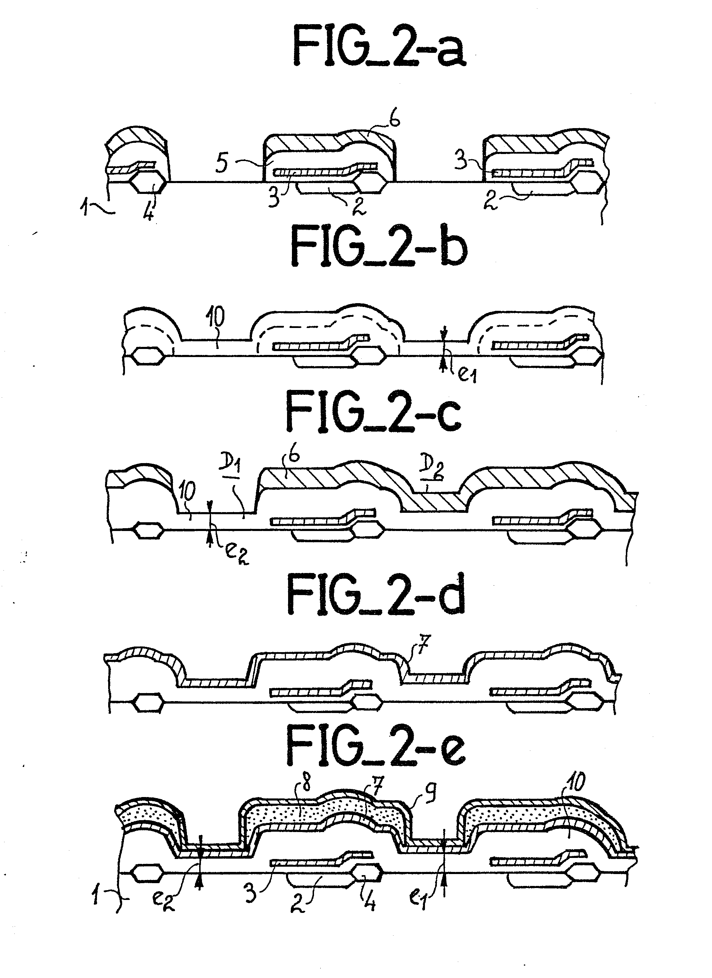

Sur les figures 2a à e, on a illustré les étapes d'un autre procédé de fabrication du dispositif de la figure 1e.

Sur la figure 2a, on voit que l'on réalise une gravure totale de la couche isolante 5 au niveau des détecteurs.

Sur la figure 2b, on dépose une couche isolante 10 ayant sensiblement l'épaisseur souhaitée pour certains des détecteurs, par exemple $e_1$ égale 2200 A.

Sur la figure 2c, on réalise un retrait complémentaire de la couche 10 au niveau du détecteur $D_1$ en protégeant le détecteur $D_2$ et les organes de stockage et de lecture par une couche de résine 6.

On obtient ainsi l'épaisseur $e_2$ de 1800 A par exemple.

Il est bien sûr possible de répéter autant de fois qu'il est souhaitable cette étape de retrait partiel pour certains détecteurs de façon à obtenir toutes les épaisseurs souhaitées.

Sur la figure 2d, la couche conductrice 7 a été déposée et sur la figure 2e, les masques en aluminium 8 et la couche isolante 9 ont été ajoutés.

Il est plus facile d'obtenir avec une bonne précision l'épaisseur de 1800 A en partant d'un dépôt de 2200 A ; alors que dans le cas des figures 1a à e les épaisseurs de 2200 et 1800 A sont obtenues à partir d'un dépôt de 1 micromètre d'épaisseur.

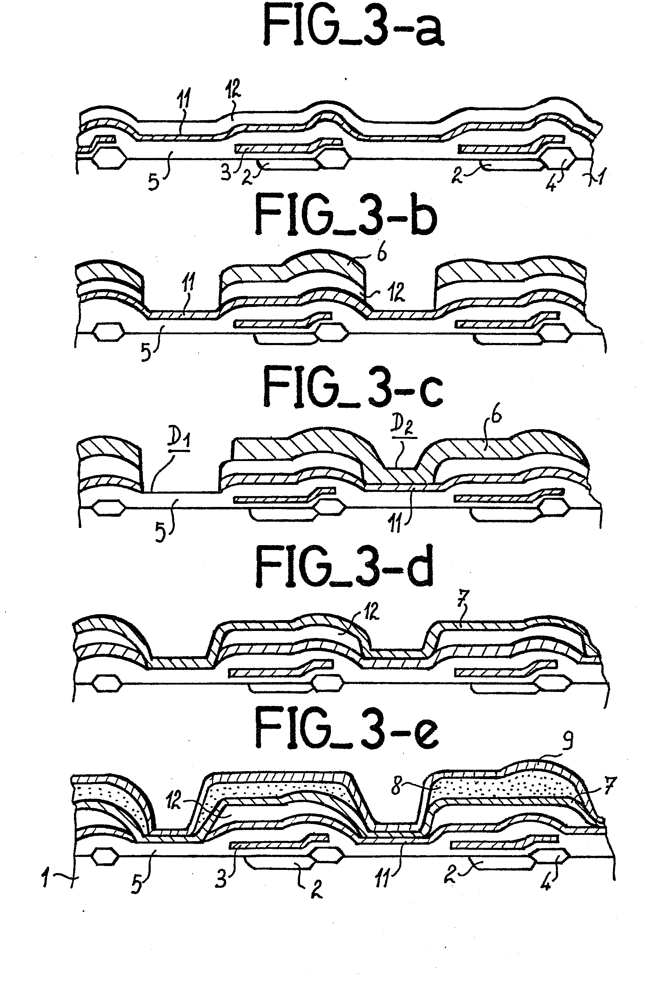

Les figures 3a à e illustrent un autre procédé de fabrication d'un dispositif tel que celui représenté sur les figures 1e et 2e.

Sur la figure 3a, on constate que le substrat semi-conducteur est recouvert de trois couches en matériau isolant 5, 11 et 12.

Les couches 5 et 11 sont de nature différente et ont chacune sensiblement l'épaisseur souhaitée pour certains des filtres.

Par exemple la couche 5 est en silice et fait 1800 A d'épaisseur et la couche 11 est en nitrure de silicium et fait de 300 à 350 A d'épaisseur.

La dernière couche 12 fait par exemple 1 micromètre d'épaisseur.

Sur la figure 3b, on montre que la couche isolante 12 est supprimée par gravure, excepté sur les organes de stockage et de lecture, qui sont protégés par une couche de résine 6.

Sur la figure 3c, on fait disparaître par gravure sélective la couche isolante 11 au-dessus du détecteur $D_1$, alors que le détecteur $D_2$ et les organes du transfert et de lecture sont protégés par une couche de résine 6. On peut utiliser la gravure par plasma.

Le détecteur $D_1$ ne comporte donc plus que la couche isolante 5, alors que le détecteur $D_2$ comporte la superposition des deux couches isolantes 5 et 11.

Sur les figures 3d et e, la couche conductrice 7, puis les masques en aluminium 8 et la couche isolante 9 sont ajoutées.

Pour obtenir plus de deux épaisseurs différentes pour la couche isolante, on peut superposer plusieurs couches isolantes, d'épaisseurs bien déterminées, et qu'il est possible de graver sélectivement.

On peut aussi à partir de l'étape 3c réaliser un ou des retraits partiels de la couche isolante 5. On peut utiliser par exemple la gravure par acide fluorhydrique dans le cas d'une couche 5 en silice.

Dans une variante, il est possible au cours de l'étape de la figure 3c de supprimer la couche 11 au-dessus de tous les détecteurs. La couche 11 ne sert alors qu'à disposer d'une couche 5 de l'épaisseur souhaitée.

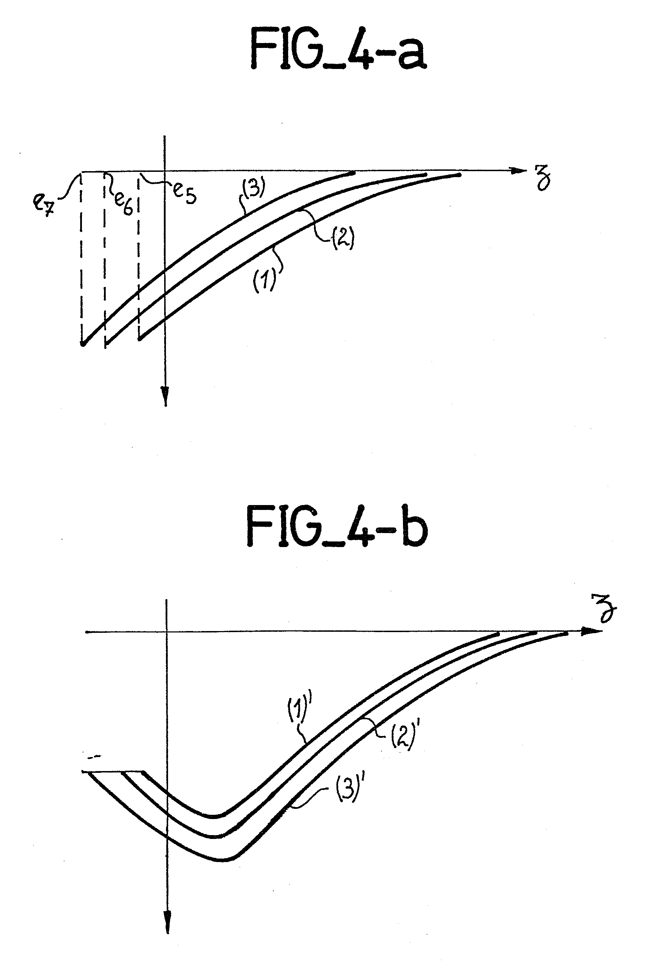

Sur la figure 4a, on a représenté trois courbes (1), (2) et (3) qui illustrent les différences de capacités de stockage pour trois détecteurs munis de filtres interférentiels intégrés et ayant une couche isolante d'épaisseur différente, on désignera par $e_5$, $e_6$ et $e_7$ ces épaisseurs.

A la plus grande épaisseur de la couche isolante correspond la plus faible capacité de stockage. Or il se trouve que si l'on utilise trois types de filtres interférentiels, l'un pour distinguer le rouge, le deuxième pour le vert et le troisième pour le bleu, la plus grande épaisseur de la couche isolante correspond au filtre rouge. Lorsqu'un dispositif photosensible reçoit de la lumière blanche, il est fréquent que la part du rayonnement rouge soit supérieure à celle des autres rayonnements. Or il se trouve que ce sont les détecteurs sensibles au rouge qui possèdent la plus faible capacité de stockage.

Il est possible de compenser ces différences de capacités de stockage pour les différents détecteurs en modifiant le dopage du substrat au niveau de chaque détecteur. Dans le cas d'un substrat de type P on réalise un dopage de type N. Ce dopage permet d'accroître la capacité de stockage des détecteurs dont la couche d'oxyde a la plus forte épaisseur.

Sur la figure 4b, les courbes (1), (2) et (3) ont été transformées après dopage en courbes (1)', (2)', (3)'. On a choisi dans cet exemple de donner la capacité de stockage la plus importante – courbe(3)' – aux détecteurs recouverts de la plus forte épaisseur d'oxyde $e_7$. On peut aussi par exemple chercher à rendre égales les diverses capacités de stockage.

Il est possible d'améliorer la sélectivité des filtres interférentiels selon l'invention en augmentant le nombre de couches en différents matériaux. On préserve généralement l'alternance couche d'indice optique élevé et couche d'indice optique faible. Cette amélioration de la sélectivité des filtres entraîne une plus grande complexité des procédés de fabrication.

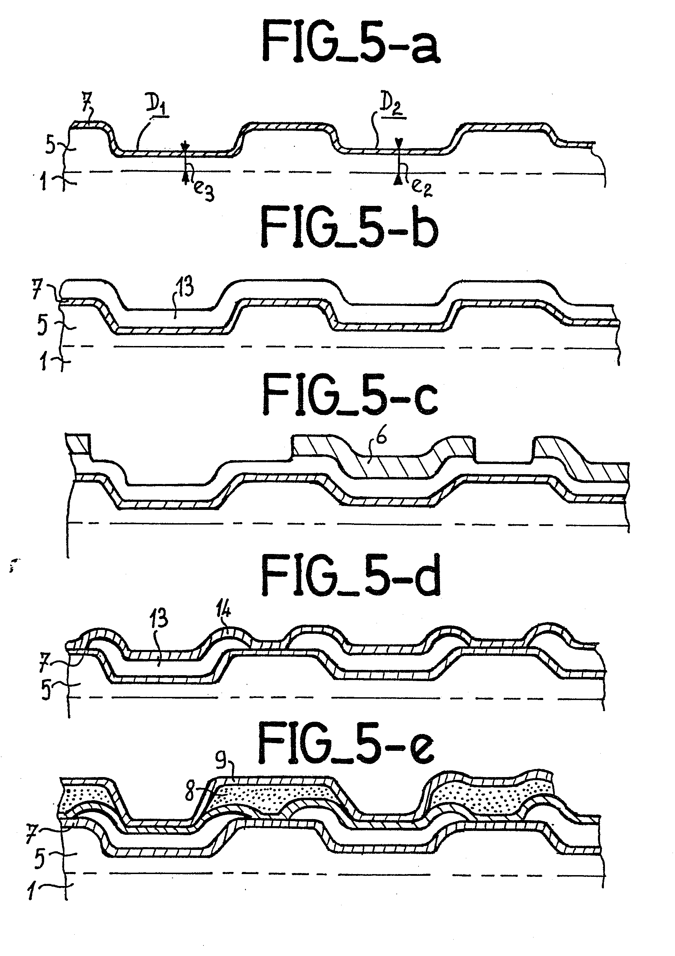

Les figures 5 a à e illustrent différentes étapes d'un procédé de fabrication d'un mode de réalisation d'un dispositif selon l'invention ainsi modifié.

Sur la figure 5a, on voit que le substrat semi-conducteur 1 est recouvert d'une couche isolante 5 d'épaisseur $e_3$ pour le détecteur $D_1$ et d'épaisseur $e_2$ pour le détecteur $D_2$.

Une couche conductrice 7 recouvre la couche isolante 5.

Sur la figure 5b, une nouvelle couche isolante 13 est déposée sur la couche conductrice 7.

Sur la figure 5c, une couche de résine 6 protège le détecteur

$D_2$ pendant qu'un retrait partiel de la couche 13 est réalisé au-dessus du détecteur $D_1$.

Sur la figure 5d, une couche 14 d'indice optique élevé est déposée.

Il peut s'agir d'une couche conductrice de l'électricité en silicium polycristallin par exemple. Dans ce cas, si comme sur la figure 5d, cette couche 14 est périodiquement en contact avec la couche 7 qui constitue les grilles des transistors MOS, on facilite la prise de contact sur ces grilles.

Sur la figure 5e, on termine le dispositif par des pavés en aluminium 8 qui protègent les organes de transfert et de lecture des charges et par une couche isolante 9 qui sert de couche anti-reflet.

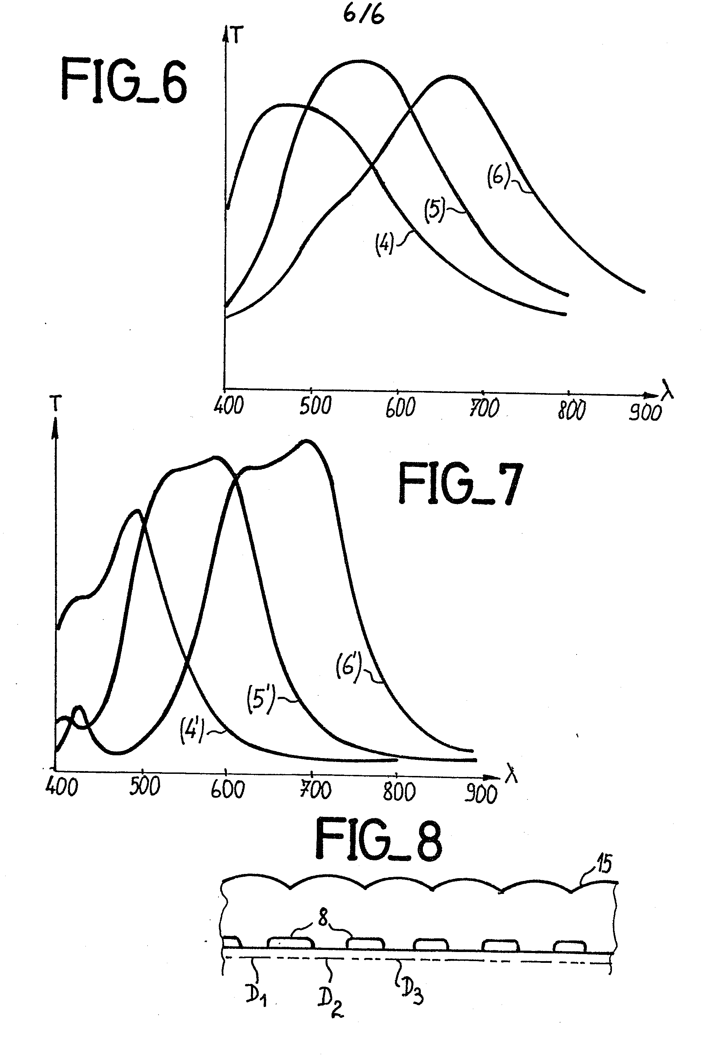

Sur la figure 6, on a représenté des courbes (4), (5) et (6) indiquant les variations de la transimission spectrale T en fonction de la longueur d'onde    dans le cas d'un dispositif tel que celui des figures 1e, 2e, ou 3e dont la couche isolante a une épaisseur de 1400 A, 1800 A et 2200 A.

. Dans l'exemple choisi, la couche isolante a un indice de 1,45, la couche conductrice a un indice voisin de 4  et une épaisseur de 400 A et la couche anti-reflet a un indice égal à 2 et une épaisseur de 600 A.

Sur la figure 7, les courbes (4)', (5)' et (6)' montrent les modifications obtenues dans le cas d'un dispositif tel que celui de la figure 5e où les mêmes épaisseurs d'isolant sont obtenues par deux couches 5 et 13.

Il s'agit là de courbes théoriques qui montrent sur la figure 7 une augmentation de l'atténuation en dehors de la bande, ce qui correspond à une augmentation de la sélectivité.

Dans le cas de la figure 5e, on utilise deux systèmes interférentiels accordés ce qui permet d'accroître la sélectivité des filtres. On peut superposer plusieurs systèmes interférentiels accordés.

Il est connu dans le domaine des dispositifs photosensibles à l'état solide d'utiliser un réseau de micro-lentilles pour réaliser une focalisation optique du rayonnement sur des détecteurs. Il s'agit là uniquement de la détection d'un rayonnement noir et blanc.

Pour améliorer la sensibilité des dispositifs photosensibles, on peut placer un tel réseau de micro-lentilles-référence 15 sur la figure 8 - au-dessus du dispositif photosensible avec ses détecteurs $D_1$, $D_2$, $D_3$... munis de filtres interférentiels intégrés. Les masques en aluminium 8 protègent les organes de transfert et de lecture dans le cas d'un dispositif à organisation interligne.Il faut noter que l'invention permet l'utilisation de micro-lentilles avec des dispositifs photosensibles couleurs.

## REVENDICATIONS

1. Dispositif photosensible comportant des détecteurs photosensibles, intégrés sur un substrat semi-conducteur (1) et munis de filtres interférentiels réalisés par plusieurs couches de différents matériaux (5, 7, 9) recouvrant le substrat semi-conducteur, caractérisé en ce que les détecteurs ($D_1$, $D_2$) sont des transistors MOS et en ce que les filtres interférentiels assurent la séparation des couleurs et sont au moins constitués par :

- au moins une couche isolante (5) en contact avec le substrat semi-conducteur (1) qui constitue la couche diélectrique des transistors MOS ;

- une couche conductrice (7) qui constitue la grille des transistors MOS.

2. Dispositif selon la revendication 1, caractérisé en ce que l'épaisseur de la ou des couches en matériau isolant (5) qui recouvrent le substrat semi-conducteur est choisie pour chaque filtre, en fonction de la transmission spectrale désirée pour ce filtre, alors que les autres couches (7, 9) constituant les filtres ont la même épaisseur pour tous les filtres.

3. Dispositif selon la revendication 2, caractérisé en ce que la variation d'épaisseur de la ou des couches en matériau isolant en fonction de la transmission spectrale désirée, est obtenue en utilisant, selon les cas, une ou plusieurs couches (5, 11) en matériau isolant superposées.

4. Dispositif selon l'une des revendications 1 à 3, caractérisé en ce que la couche conductrice (7) est recouverte d'une couche isolante (9) qui sert de couche anti-reflet.

5. Dispositif selon l'une des revendications 1 à 3, caractérisé en ce que la couche conductrice (7) est recouverte :

- d'une couche isolante (13) ;

- d'une couche d'indice optique élevé (14) ;

- d'une couche isolante (9) qui sert de couche anti-reflet.

6. Dispositif selon la revendication 5, caractérisé en ce que la

**0152353**

couche d'indice optique élevé (14) est une couche conductrice périodiquement en contact avec la couche conductrice qui constitue la grille des transistors MOS.

7. Dispositif selon l'une des revendications 2 à 6, caractérisé en ce que le dopage du substrat est modifié au niveau de chaque détecteur pour compenser le déséquilibre des capacités de stockage des détecteurs qui résulte des différences d'épaisseur selon les filtres de la ou des couches en matériau isolant.

8. Dispositif selon l'une des revendications 1 à 7, caractérisé en ce qu'il est recouvert par un ensemble de micro-lentilles (15) focalisant le rayonnement à détecter sur les détecteurs ($D_1$, $D_2$, $D_3$).

9. Procédé de fabrication d'un dispositif selon l'une des revendications 1 à 8, caractérisé en ce qu'il comporte les étapes suivantes :

- 1°) - on dépose une couche en matériau isolant (5) de forte épaisseur ($e_1$) ;

- 2°) - on réalise un retrait partiel de la couche en matériau isolant située au-dessus de chaque détecteur de façon à obtenir sensiblement l'épaisseur souhaitée ($e_2$) pour certains des filtres ;

- 3°) - on réalise un retrait complémentaire de la couche en matériau isolant située au-dessus de certains détecteurs ($D_1$), tout en protégeant les autres détecteurs ($D_2$) de façon à obtenir sensiblement l'épaisseur ($e_3$) souhaitée pour certains des filtres ;

- 4°) - on répète éventuellement l'étape précédente de façon à obtenir autant d'épaisseurs différentes de la couche en matériau isolant que cela est souhaité.

10. Procédé de fabrication d'un dispositif selon l'une des revendications 1 à 8, caractérisé en ce qu'il comporte les étapes suivantes :

- 1°) - on dépose une couche en matériau isolant (10) sensiblement de l'épaisseur souhaitée ($e_1$) pour certains des filtres ;

- 2°) - on réalise un retrait partiel de la couche en matériau isolant située au-dessus de certains détecteurs ($D_1$), tout en protégeant les autres détecteurs ($D_2$), de façon à obtenir sensiblement

l'épaisseur souhaitée ($e_2$) pour certains des filtres ;

- 3°) - on répète éventuellement l'étape précédente de façon à obtenir autant d'épaisseurs différentes de la couche en matériau isolant que cela est souhaité.

11. Procédé de fabrication d'un dispositif selon l'une des revendications 1 à 8, caractérisé en ce qu'il comporte les étapes suivantes :

- 1°) on dépose en les superposant au moins deux couches en matériau isolant (5, 11) de nature différente, ayant sensiblement l'épaisseur souhaitée pour certains des filtres ;

- 2°) on fait disparaître par gravure sélective l'une des couches (11) en matériau isolant située au-dessus de certains détecteurs ($D_1$), tout en protégeant les autres détecteurs ($D_2$) ;

- 3°) on répète éventuellement l'étape précédente si plus de deux couches isolantes ont été superposées ;

- 4°) on réalise éventuellement un retrait partiel de la couche en matériau isolant située au-dessus de certains détecteurs, de façon à obtenir sensiblement l'épaisseur souhaitée par certains des filtres.

# FIG_1-a

# FIG_1-b

# FIG_1-c

# FIG_1-d

# FIG_1-e

0152353

2/6

FIG_2-a

FIG_2-b

FIG_2-c

FIG_2-d

FIG_2-e

## FIG_3-a

## FIG_3-b

## FIG_3-c

## FIG_3-d

## FIG_3-e

# FIG_4-a

# FIG_4-b

0152353

# FIG_5-a

$D_1$   $D_2$

$e_3$   $e_2$

# FIG_5-b

13

# FIG_5-c

6

# FIG_5-d

13   14

# FIG_5-e

9   8

0152353

FIG_6

FIG_7

FIG_8

(4) (5) (6)

(4') (5') (6')

$D_1$ $D_2$ $D_3$

8

15

**0152353**

Numéro de la demande

# Office européen des brevets

# RAPPORT DE RECHERCHE EUROPEENNE

EP  85 40 0213

## DOCUMENTS CONSIDERES COMME PERTINENTS

| Catégorie | Citation du document avec indication. en cas de besoin, des parties pertinentes | Revendication concernée | CLASSEMENT DE LA DEMANDE (Int. Cl.4) |
|---|---|---|---|
| D,Y | FR-A-2 362 412  (SIEMENS AG) <br> * Page 3,  lignes 4-20; page 6, ligne 1 - page 9, ligne 31; revendications 1-3,5,7,13,14; figures 2,3,5 * | 1 | H 01 L  31/02 <br> H 01 L  31/10 |
| A | | 3,5,9, 11 | |
| Y | FR-A-2 362 495  (HITACHI LTD.) <br> * Page 1; page 4, lignes 1-24; revendications; figures 1,2 * | 1 | |
| A | | 4 | |
| A | US-A-3 076 861  (H.A. SAMULON et al.) <br> * En entier * | 1,3-5 | DOMAINES TECHNIQUES RECHERCHES (Int. Cl.4) |
| A | US-A-3 247 392  (A.J. THELEN) <br> * Colonne  2, ligne 40 - colonne 3,  ligne 36;  colonne 6, lignes 55-71;  revendications 1,3,7,8,20 * | 1-3 | H 01 L |
| A | US-A-3 996 461  (F.C. SULZBACH et al.) <br> * En entier * | 1-3,9, 11 | |
| | ---     -/- | | |

Le présent rapport de recherche a été établi pour toutes les revendications

| Lieu de la recherche <br> LA HAYE | Date d'achèvement de la recherche <br> 24-04-1985 | Examinateur <br> VISENTIN A. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

      & : membre de la même famille, document correspondant

OEB Form 1503. 03.82

## DOCUMENTS CONSIDERES COMME PERTINENTS

Page 2

| Catégorie | Citation du document avec indication, en cas de besoin, des parties pertinentes | Revendication concernée | CLASSEMENT DE LA DEMANDE (Int Cl 4) |
|---|---|---|---|
| A | IEEE JOURNAL OF SOLID-STATE CIRCUITS, vol. SC-17, no. 2, avril 1982, pages 375-380, IEEE, New York, US; M. AOKI et al.: "2/3-Inch format MOS single-chip color imager" | | |

DOMAINES TECHNIQUES RECHERCHES (Int. Cl.4)

Le présent rapport de recherche a été établi pour toutes les revendications

| Lieu de la recherche | Date d'achèvement de la recherche | Examinateur |
|---|---|---|
| LA HAYE | 24-04-1985 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82